# EUROPÄISCHE PATENTSCHRIFT

(11) **EP 1 116 281 B1**
(45) Veröffentlichungstag und Bekanntmachung des Hinweises auf die Patenterteilung: **23.02.2011**
(21) Anmeldenummer: 99947380.4
(22) Anmeldetag: 17.09.1999
(51) Int. Cl.: H01L 31/18, H01L 27/142, G02F 1/1343

(54) **VERFAHREN ZUR STRUKTURIERUNG VON TRANSPARENTEN ELEKTRODENSCHICHTEN**
METHOD FOR STRUCTURING TRANSPARENT ELECTRODE LAYERS
PROCEDE DE STRUCTURATION DE COUCHES D'ELECTRODES TRANSPARENTES

(30) Priorität: 17.09.1998 DE 19842679
(43) Veröffentlichungstag der Anmeldung: 18.07.2001
(73) Patentinhaber: Saint-Gobain Glass France S.A., 92400 Courbevoie (FR)
(72) Erfinder: KARG, Franz, D-80689 München (DE)
(74) Vertreter: Lendvai, Tomas
(86) Internationale Anmeldenummer: PCT/EP1999/006905
(87) Internationale Veröffentlichungsnummer: WO 2000/017942

(56) Entgegenhaltungen:
- EP-A- 0 213 910
- EP-A- 0 536 431
- EP-A- 0 763 858
- US-A- 5 607 601
- S. NAKANO ET AL.: "Laser patterning method for integrated type a-Si solar cell submodules" JAPANESE JOURNAL OF APPLIED PHYSICS., Bd. 25, Nr. 12, Dezember 1986 (1986-12), Seiten 1936-1943, XP002127544 PUBLICATION OFFICE JAPANESE JOURNAL OF APPLIED PHYSICS. TOKYO., JP ISSN: 0021-4922

## Beschreibung

Die vorliegende Erfindung betrifft ein Verfahren zur Strukturierung von transparenten, leitfähigen Schichten, insbesondere ein Verfahren zur Strukturierung von transparenten Elektrodenschichten in Dünnschichtbauelementen.

Die Herstellung von Dünnschichtbauelementen, wie zum Beispiel Photovoltaikmodule, flache Bildschirme oder schaltbare Fenster, die in der Großfächenelektronik weite Anwendung finden, benötigt neben geeigneten Beschichtungsverfahren kostengünstige Strukturierungsmethoden. Die Dünnschichtbauelemente werden durch bekannte Depositionsverfahren in der Regel ganzflächig abgeschieden und anschließend unter Verwendung geeigneter Strukturierungsprozesse durch Entfernen definierter und räumlich scharf begrenzter Bereiche strukturiert.

Eine derartige Strukturierung von Dünnschichten ist beispielsweise bei der integrierten Serienverschaltung von Photovoltaikmodulen notwendig. Es ist bekannt, daß derartige Module durch Abscheiden im wesentlichen von drei funktionellen Schichten hergestellt werden. Eine erste Schicht wird beispielsweise durch Aufdampfen auf ein Substrat abgeschieden und dient als erste Elektrodenschicht. Auf diese erste Elektodenschicht wird eine Absorberschicht aufgetragen, die aus einem entsprechend dotierten Halbleiter besteht. Auf diese Absorberschicht wird in einem weiteren Schritt eine zweite Elektrodenschicht aufgedampft. Diese zweite Elektrode ist im allgemeinen für Strahlung im sichtbaren Spektralbereich' transparent, um im Fall eines Solarmoduls eine geringe Schwächung des einstrahlenden Sonnenlichtes zu gewährleisten. Zum Schutz vor Umwelteinflüssen kann dieser Dünnschichtaufbau mittels einer Kunststoffmasse und optional mit einer zweiten Platte versiegelt werden.

Um bei der Hestellung derartiger Dünnschichtbauelemente die gesamte Modulfläche besser auszunutzen oder bei serienverschalteten Solarmodulen die Gesamtmodulspannung von unter 1 V einer Einzelzelle auf 12V oder 24V eines Moduls zu erhöhen, wird die Gesamtmodulfläche in mehrere Einzelzellen aufgeteilt. Dies benötigt eine Strukturierung der verschiedenen funktionellen Schichten. Die Serienverschaltung umfaßt typischerweise mindestens drei Strukturierungsschritte zum Strukturieren der ersten Elektrodenschicht, der Absorberschicht und der zweiten Elektodenschicht.

Hierbei ist es wichtig, daß die Strukturierungstechnologie nur geringe Kosten verursacht, d.h., daß die Strukturierung mit hohem Durchsatz und langer Standzeit durchgeführt wird. Zudem muß das verwendete Strukturierungsverfahren schmale Strukturierungsbreiten herstellen, um die Verluste an aktiver Modulfläche zu minimieren. Die Strukturierung darf zudem keine Schädigung oder Verschmutzung anliegender oder darunter liegender Halbleiter- oder Elektrodenschichten bewirken, d.h. die Selektivität des Strukturierungsprozesses sollte möglichst hoch sein.

Bei den bekannten Strukturierungsverfahren wird die Stukturierung der zuerst abgeschiedenen ersten Elektrodenschicht und die der anschließend abgeschiedenen Absorberschicht mit Hilfe von Excimer oder Nd:YAG-Lasern durchgeführt. Zur Strukturierung der transparenten Elektrodenschicht werden photolitographische Strukturierungsverfahren bzw. Ätzverfahren, Abhebetechniken und mechanische Strukturierungsverfahren verwendet. Diese bekannten Verfahren weisen allerdings einige Nachteile auf. Das Photolitographieverfahren ist meist teuer und mehrere Prozeßschritte sind nötig, um die gewünschte Strukturierung durchzuführen. Bei den bekannten Abhebetechniken werden die in einem späteren Prozeßschritt abzuhebenden Flächen mittels Siebdruck oder Pastenschreiben beschichtet was ebenfalls mehrere Prozeßschritte beinhaltet (z.B. Pastenschreiben sowie die anschließende Ablösung). Außerdem kann die Strukturierungsbreite kaum unter 100 µm reduziert werden. Letzteres gilt auch für die mechanische Strukturierung, die zwar keine thermische Belastung verursacht, aber weiche darunter liegende Schichten ebenfalls entfernt. Die geforderte Selektivität innerhalb des Schichtaufbaus ist hier demnach nicht gewährleistet. Als zusätzliches Problem ist die Lockerung bzw. Ablösung der an die Strukturierungslinie angrenzenden Schichtbereiche zu verzeichnen, die bei thermischer Wechselbelastung zur totalen Schichtablösung und zu Stabilitätsproblemen des Moduls führen kann.

EP 763 858 A2 beschreibt die Strukturierung einer Schicht von Indium-Zinn-Oxid in einem photovoltaischen Element mit Hilfe eines Nd-YAG-Lasers bei einer Wellenlänge von 1,06 µm.

Chopra et al. beschreiben in Thin Solid Films, vol. 102 (1983), S. 1-46, Eigenschaften von transparenten Leitern, darunter optische Eigenschaften von Indium-Zinn-Oxid. Somit weisen die bekannten Verfahren zur Strukturierung von transparenten Elektrodenschichten den Nachteil auf, daß sie keine ausreichende Selektivität aufweisen, keine ausreichend kleine Strukturierungsbreite ermöglichen und zudem in der Regel mit hohen Kosten verbunden sind.

Es ist somit die Aufgabe der vorliegenden Erfindung, ein Verfahren zum Strukturieren von transparenten Schichten bereitzustellen, das eine geringe Strukturierungsbreite gewährleistet, flexibel bezüglich des Layouts der Strukturierung ist, eine hohe Reproduzierbarkeit und eine hohe Prozeßreinheit aufweist, und zudem kostengünstig ist.

Gelöst wird diese Aufgabe durch ein Verfahren mit den Merkmalen des Patentanspruchs 1.

Weitere vorteilhafte Ausgestaltungen ergeben sich aus den Unteransprüchen.

Ein zentraler Gedanke ist hierbei, daß die Laserenergie eines zur Strukturierung einer transparenten Schicht verwendeten Lasers effizient und ausschließlich in die transparente Schicht eingekoppelt wird, und von der darunter liegenden Schicht weder reflektiert noch transmittiert wird, um somit die darunter liegende Schicht nicht thermisch zu schädigen. Diese Anforderung wird dadurch erfüllt, daß die Laserwellenlänge derart ausgewählt wird, daß sie in den Bereich der Plasmaabsorption der transparenten Schicht fällt.

Im folgenden wird die Erfindung unter Bezugnahme auf die begleitenden Abbildungen genauer beschrieben, in denen zeigt:
- Fig. 1: einen schematischen Aufbau eines herkömmlichen Dünnschichtsolarmoduls, dessen Gesamtfläche in 10 serienverschaltete Einzelzellen unterteilt ist; und
- Fig. 2: eine schematische Übersichtsdarstellung der Wechselwirkung von Strahlung mit Halbleitern in Relation zu einer transparenten Elektrodenschicht.

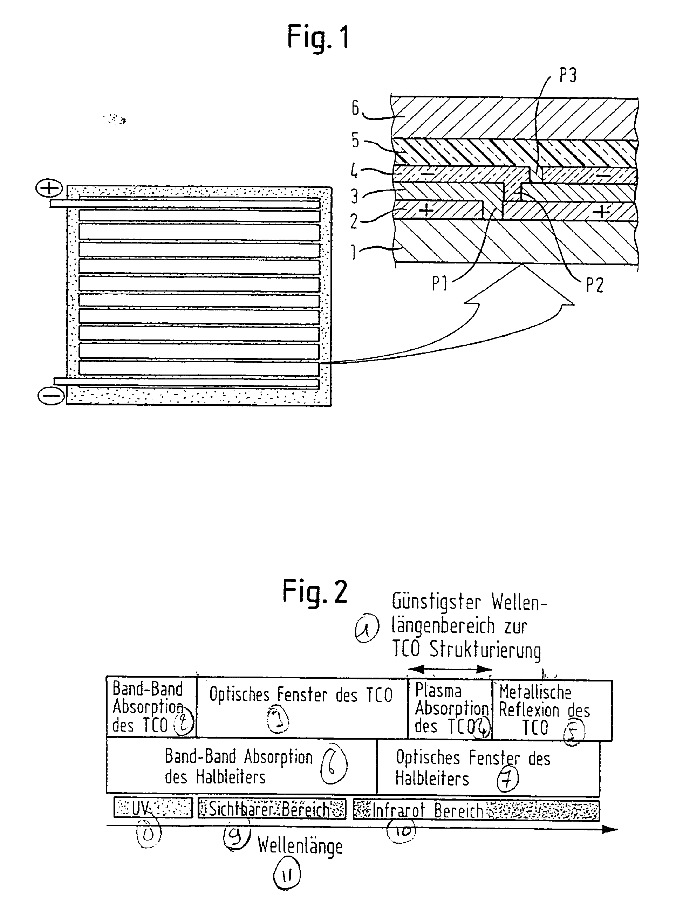

Fig. 1 zeigt einen schematischen Aufbau eines herkömmlichen Dünnschichtsolarmoduls. In der linken Abbildung der Fig. 1 ist eine Draufsicht auf die Gesamtfläche des Dünnschichtsolarmoduls gezeigt. Die Gesamtfläche ist hier in 10 serienverschaltete Einzelzellen unterteilt. Der Schichtaufbau des Dünnschichtsolarmoduls geht aus der rechten Abbildung der Fig. 1 hervor. Das Dünnschichtmodul weist ein Substrat 1 auf, auf dem eine erste Elektrodenschicht 2 abgeschieden ist. In einem ersten Strukturierungsschritt P1 wird die erste Elektrode, die auch als Rückelektrode des Solarmoduls dient, entsprechend strukturiert. Anschließend wird eine Absorberschicht 3 auf der strukturierten Rückelektrode abgeschieden und in einem weiteren Strukturierungsschritt P2 entsprechend eines gewünschten Layouts strukturiert. Die Absorberschicht 3 besteht typischerweise aus einem Halbleiter mit geeignetem Bandabstand von 0,8 bis 1,8 eV, und weist eine hohe Absorptionscharakteristik auf. Ebenso wie der Strukturierungsschritt P1 wird der Strukturierungsschritt P2 mit Hilfe eines Excimer oder Nd:YAG-Lasers durchgeführt. Auf die Absorberschicht 3 wird anschließend in einem weiteren Schritt eine zweite Elektrodenschicht 4 aufgetragen. Diese Elektrodenschicht 4 dient als Frontelektrode und ist vorzugsweise im sichtbaren Spektralbereich transparent, um auf das Solarmodul einstrahlende Sonnenlicht möglichst ohne Schwächung durchzulassen, um dann von der entsprechend dotierten Halbleiterschicht 3 absorbiert zu werden. Auch die transparente Elektrodenschicht 4 muß in einem weiteren Strukturierungsschritt P3 strukturiert werden, um eine geeignete Verschaltung der Einzelzellen des Dünnschichtmoduls zu gewährleisten. Diese Schichtstruktur kann zum Schutz vor Umwelteinflüssen versiegelt werden, z.B. mit einer Kunstoffmasse (5) und/oder einer zweiten Platte (6).

Derartige transparente Frontelektroden 4 bestehen in der Regel aus dotierten Metalloxiden (Transparent Conductive Oxides, TCOs) wie z.B. Indium-Zinn-Oxid (ITO), flur- oder antimondotiertes SnO₂, bor-, aluminium-, indium- oder galliumdotiertes ZnO. Diese Materialien weisen ein optisches Fenster im sichtbaren und nahen infraroten Spektralbereich auf. Für Energien überhalb der Bandlücke und im längerwelligen Spektralbereich tritt jedoch verstärkte Absorption auf. Ersteres ist auf direkte Band-Band-Übergänge, letzteres auf die sog. Plasmaabsorption zurückzuführen. Im fernen Infrarot verhalten sich diese dotierten Metalloxide unter optischen Gesichtspunkten wie ein reines Metall, d.h. sie reflektieren die einfallende Strahlung zu einem großen Teil.

Ein optisches Strukturierungsverfahren derartiger TCO-Schichten erfordert eine entsprechende Energieeinkopplung in das Metalloxid. Dies ist gemäß der optischen Absorptionscharakteristik prinzipiell in zwei Wellenlängenbereichen möglich, wie das in Fig. 2 dargestellt ist.

Fig. 2 zeigt eine schematische Übersichtsdarstellung der Wechselwirkung von Strahlung mit Halbleitern in Relation zu der transparenten TCO-Frontelektrode. In Fig. 2 ist der Wellenlängenbereich nach rechts aufgetragen. Der UV-Spektralbereich, der sichtbare Bereich und der Infrarotbereich sind entsprechend markiert. Analog zu der Schichtstruktur eines Dünnschichtmoduls ist in Fig. 2 die Absorptionscharakteristik einer typischen Halbleiterschicht dargestellt, und darüber die einer typischen transparenten Frontelektrode aus TCO. Aus Fig. 2 geht auch hervor, daß die unterschiedlichen Absorptionsbereiche der transparenten TCO-Elektrodenschichten im Vergleich zum darunter liegenden Halbleiter zu kürzeren Wellenlängen hin verschoben ist. Der Grund für diese Verschiebung liegt im höheren Bandabstand und in der höheren Leitfähigkeit der transparenten Elektrodenschicht im Vergleich zur halbleitenden Absorberschicht. Somit fallen die unterschiedlichen Absorptionsbereiche der Elektrodenschicht und der Absorberschicht nicht übereinander.

Im hochenergetischen UV-Bereich kann beispielsweise unter Verwendung eines Excimer-Lasers Energie in das Metalloxid eingekoppelt werden. Die Absoption der Laserenergie beruht auf Band-Band Absorption des TCOs in diesem Energiebereich. Nachteil dieses Verfahren ist unter anderem, daß eine UV-Anregung häufig zur Dissoziation der Metalloxide, d.h. zur Abspaltung von Sauerstoff und zum Verbleib reiner Metalloberflächen führt. Dies ist jedoch für die eingangs beschriebenen Dünnschichtmodule nicht wünschenswert, und somit weist eine Strukturierung in dem UV-Bereich unter Verwendung von Lasern gravierende Nachteile auf.

An den hochenergetischen Bereich der Band-Band Absorption schließt sich ein niederfrequenter Bereich an, der in einen "Fensterbereich", in einen "Plasmaabsorptionsbereich" und in einen Bereich "metallischer Reflexion" unterteilt werden kann. Folglich ist nicht nur im ultravioletten Strahlungsbereich ein Absorptionsbereich zu finden, sondern auch im infraroten Strahlungsbereich aufgrund von freier Trägerabsorption, der sogenannten Plasmaabsorption.

Der sich unmittelbar an den Band-Band-Absorptionsbereich des TCOs anschließenden optische Fensterbereich ist für Strahlung im sichtbaren Bereich transparent. An den niederenergetischen Bereich dieses optischen Fensters schließt sich der Plasmaabsorptionsbereich an. Die Strahlungsenergie durchdringt in diesem langwelligen Bereich nicht mehr vollständig die transparente Elektrodenschicht, sondern klingt innerhalb der Skintiefe in Intensität ab. Folglich wird die einfallende Strahlung zum Teil in der Schicht absorbiert oder von der Schicht reflektiert. Bei weiter ansteigenden Wellenlängen fällt das Verhältnis von absorbierter zu reflektierter Energie wiederum ab, d.h. der zur Erhitzung der Elektrodenschicht zur Verfügung stehende Energieanteil wird geringer. Zu längeren Wellenlängen hin schließt sich an den Bereich der Plasmaabsorption der Bereich der metallischen Reflexion. Bei der metallischen Reflexion wird die Strahlungsenergie zu einem Prozentsatz von > 50% reflektiert und ist somit nicht geeignet, um ausreichend Energie in die Elektrodenschicht einzukoppeln. Zudem sei angemerkt, daß zwar in Fig. 2 die unterschiedlichen Absorptionsbereiche abrupte Übergänge aufweisen, real die einzelnen Bereiche jedoch kontinuierlich innerhalb eines gewissen Übergangsbereiches ineinander übergehen.

Der günstige Wellenlängenbereich zur Strukturierung einer TCO-Schisht liegt im Bereich der Plasmaabsorption. Der zur Strukturierung einer transparenten Elektrodenschicht verwendete Laser muß daher eine Wellenlänge λ aufweisen, die folgende drei Bedingungen erfüllt:
a) Die Wellenlänge λ des Lasers muß größer als die Grenzwellenlänge λ_{g} ^{opt} für optische Absorption im darunter liegenden Absorber sein;
b) die Wellenlänge λ des Lasers muß größer als die Grenzwellenlänge für freie Trägerabsorption (Plasmaabsorption) λ_{g}^{pla} in der transparenten Elektrodenschicht sein; und
c) die Wellenlänge λ des Lasers muß kleiner als die Grenzwellenlänge für metallische Reflexion λ_{g}^{met} an der transparenten Frontelektrode sein.

Die Bedingung a) gewährleistet, daß keine Strahlung im Absorber absorbiert wird und somit nur geringe direkte Erwärmung entsteht, was die Schädigung der Halbleiterschicht gering hält. Die Grenzwellenlänge λ_{g}^{opt} für eine CuInSe₂-Absorberschicht beträgt beispielsweise 1,2µm, für eine Si-Absorberschicht 1,13µm, für eine CdTe-Absorberschicht 0,86 µm und für eine a-Si:H-Absorberschicht 0,7 µm.

Ferner sei angemerkt, daß die Grenzwellenlänge λ_{g}^{pla} (Bedingung b)) unter anderem proportional zu inversen Wurzeln aus der freien Trägerdichte ist, und zum Beispiel von der Dotierung der Elektrodenschicht abhängt. Bei einer typischen transparenten Elektrode mit einer Leitfähigkeit von ca. 10⁺³ (Ω cm)⁻¹ beginnt dieser Bereich bei etwa 1200 bis 1400 nm.

Andererseits fällt die Grenzwellenlänge λ_{g}^{met} (Bedingung c)) mit steigender Dotierung und spezifischer Leitfähigkeit der Frontelektrode. Sie ist im Einzelfall durch optische Messung zu klären. Je höher der Reflexionsanteil, desto mehr Energie ist zur Strukturierung erforderlich. Prinzipiell kann auch mit höherer Laserwellenlänge strukturiert werden. Die Gefahr parasitärer Nebeneffekte steigt jedoch mit der Energie. Der Reflexionsanteil sollte nach Möglichkeit 50% nicht übersteigen.

Als Beispiel für die Auswahl einer geeigneten Laserwellenlänge ist eine Schichtstruktur bestehend aus einer ZnO:Al:Frontelektrode auf einem CuInSe₂-Absorber gewählt. Die untere Grenzwellenlänge λ_{g}^{opt} für CIS beträgt 1,2 µm. Die Plasmaabsorption in ZnO:Al bei einer Al-Konzentration von ca. 1-2% beginnt bei einer Grenzwellenlänge λ_{g}^{pla} von ca. 1,3 µm. Die Grenzwellenlänge λ_{g}^{met}, bei der die metallische Reflexion noch tolerierbar ist, d.h. bei weniger als 50% liegt, beträgt ungefähr 3 µm. Somit liegt der in Frage kommende Wellenlängenbereich für dieses Beispiel zwischen 1,3 und ca. 3 µm.

Mit einem auf unter 100 µm Strahldurchmesser fokussierten, gepulsten Er:YAG-Laser wurden bei 2,94 µm Wellenlänge ZnO:Al Frontelektroden mit einer Pulsenergiedichte von unter 5 J/cm² ohne Schädigung der darunter liegenden CuInSe₂-Absorberschicht abgehoben. Im Gegensatz dazu führte der gleiche Versuch mit einem Nd:YAG-Laser (1064 nm oder 532nm) zum Aufschmelzen des darunter liegenden CIS-Halbleiters und infolgedessen zu Kurzschlüssen in der Solarzellenstruktur.

Das oben beschriebene Verfahren ist nicht auf die Strukturierung von Dünnschichtsolarmodulen beschränkt, sondern kann auf andere Dünnschichtbauelemente angewendet werden, die transparente Elektrodenschichten aufweisen.

## Patentansprüche

1. Verfahren zur Strukturierung einer transparenten, leitfähigen Schicht oberhalb einer Absorberschicht, wobei ein Laser verwendet wird mit einer Wellenlänge (λ) die größer ist als die Grenzwellenlänge für Plasmaabsorption der transparenten leitfähigen Schicht (4) ist, ohne somit die darunterliegende Absorberschicht thermisch zu schädigen
**dadurch gekennzeichnet, dass** die Absorberschicht (3) eine CuInSe₂-Absorberschicht (3) ist, und
dass bei einer Schichtstruktur bestehend aus ZnO:Al-Elektrode, und einem CuInSe₂-Absorber die Wellenlänge (λ) des Lasers auf einen Wert zwischen 1,3 und 3 µm eingestellt wird.

2. Verfahren nach Anspruch 1, **dadurch gekennzeichnet, dass** die Wellenlänge (λ) des Lasers auf 2,94 µm eingestellt wird, der Strahlendurchmesser des Lasers unter 100 µm beträgt und der Laser ein gepulster Er : YAG-Laser ist, der eine Pulsenergiedichte von weniger als 5 J/cm² aufweist.

3. Verfahren nach einem der Ansprüche 1 bis 2 zur Herstellung von Photovoltaikmodulen und anderen Dünnschichtbauelementen.

## Claims

1. Method for structuring a transparent, conductive layer over an absorber layer, in which a laser is used with a wavelength that is greater than the threshold wavelength for plasma absorption of the transparent conductive layer (4), without thermally damaging the underlying absorber layer, **characterized in that** the absorber layer (3) is a CuInSe₂-absorber layer (3), and that with a layer structure consisting of a ZnO:Al-electrode and a CuInSe₂-absorber, the wavelength (λ) of the laser is set to a value between 1.3 and 3 µm.

2. Method according to claim 1, **characterized in that** the wavelength (λ) of the laser is set to 2.94 µm, the beam diameter of the laser is less than 100 µm, and the laser is a pulsed Er : YAG-laser that has a pulsed energy density of less than 5 J/cm².

3. Method according claim 1 or 2 for producing photovoltaic modules and other thin-film components

## Revendications

1. Procédé de structuration d'une couche conductrice transparente au-dessus d'une couche absorbante, un laser étant utilisé avec une longueur d'onde (λ) qui est supérieure à la longueur d'onde limite pour l'absorption plasma de la couche conductrice transparente (4) sans donc endommager thermiquement la couche absorbante sous-jacente, **caractérisé par le fait que** la couche absorbante (3) est une couche absorbante (3) de CuInSe₂, et que, dans le cas d'une structure de couches se composant d'une électrode de ZnO : Al et d'un absorbeur CuInSe₂ , la longueur d'onde (λ) du laser est réglée à une valeur entre 1,3 et 3 µm.

2. Procédé selon la revendication 1, **caractérisé par le fait que** la longueur d'onde (λ) du laser est réglée à 2,94 µm, le diamètre de rayonnement du laser se situe au-dessous de 100 µm et le laser est un laser Er : YAG pulsé qui possède une densité d'énergie d'impulsion de moins de 5 J/cm².

3. Procédé selon l'une des revendications 1 et 2, pour la fabrication de modules photovoltaïques et autres composants à couches minces.
